# EUROPÄISCHE PATENTANMELDUNG

(11) **EP 2 196 556 A1**
(43) Veröffentlichungstag der Anmeldung: **16.06.2010**
(21) Anmeldenummer: 10156757.6
(22) Anmeldetag: 26.03.2003
(51) Int. Cl.: C23C 14/26, C23C 14/30, C23C 14/20, G07D 7/12, B42D 15/00

(54) **Sicherheitselement und Verfahren zu seiner Herstellung**

(30) Priorität: 28.03.2002 DE 10214330
(62) Teilanmeldung aus: 03745273.7
(71) Anmelder: Giesecke & Devrient GmbH, 81677 München (DE)
(72) Erfinder: Heim, Manfred, 83646 Bad Tölz (DE); Burchard, Theodor, 83703 Gmund (DE)
(74) Vertreter: Klunker . Schmitt-Nilson . Hirsch

(57) **Zusammenfassung**

Die Erfindung betrifft einen Gegenstand, insbesondere ein Sicherheitselement für Sicherheitspapiere, Banknoten, Ausweiskarte oder dergleichen, sowie ein Sicherheitspapier und ein Wertdokument mit einem derartigen Sicherheitselement. Ferner betrifft die Erfindung ein Verfahren zur Herstellung des Gegenstandes, insbesondere des Sicherheitselements bzw. des Sicherheitspapiers und des Wertdokuments mit einem derartigen Sicherheitselement. Das Verfahren dient insbesondere für die Erzeugung einer edelmetallfarbenen, vorzugsweise goldfarbenen Beschichtung auf einem Substrat.

## Beschreibung

Die Erfindung betrifft einen Gegenstand, insbesondere ein Sicherheitselement für Sicherheitspapiere, Banknoten, Ausweiskarte oder dergleichen, sowie ein Sicherheitspapier und ein Wertdokument mit einem derartigen Sicherheitselement. Ferner betrifft die Erfindung ein Verfahren zur Herstellung des Gegenstandes, insbesondere des Sicherheitselements bzw. des Sicherheitspapiers und des Wertdokuments mit einem derartigen Sicherheitselement. Das Verfahren dient insbesondere für die Erzeugung einer edelmetallfarbenen, vorzugsweise goldfarbenen Beschichtung auf einem Substrat.

Bei der Herstellung von Wertdokumenten, worunter im Rahmen der vorliegenden Erfindung beispielsweise Banknoten, Scheckformulare, Aktien, Ausweise, Kreditkarten, Flugscheine und andere Urkunden und Dokumente sowie Etiketten, Siegel, Verpackungen und andere Elemente für die Produktsicherung zu verstehen sind, ist es besonders wichtig, Vorkehrungen gegen Verfälschung und/oder Maßnahmen zur Feststellung der Echtheit zu treffen. Neben den Merkmalen, die insbesondere bei der Prüfung durch Automaten erkannt bzw. eingesetzt werden können, existieren auch Merkmale, die von jedermann ohne technische Hilfsmittel und ohne besonderes Fachwissen eindeutig zur Echtheitserkennung auf derartige Dokumente aufgebracht werden können.

Eine Möglichkeit, ein Sicherheitselement, wie einen Sicherheitsfaden mit visuell leicht erkennbaren Elementen auszustatten, beschreibt die EP 0 330 733 B1, in der ein Sicherheitsfaden mit Aussparungen in einer opaken Schicht versehen ist, und in den Aussparungen farbgebende und/ oder lumineszierende Substanzen enthält. Dieser Sicherheitsfaden wird als so genannter "Fenstersicherheitsfaden" in Sicherheitspapiere eingebettet, d.h. er wird während der Blattbildung des Sicherheitspapiers quasi in das Papier eingewebt, so dass er in regelmäßigen Abständen an der Oberfläche des Papiers frei zugänglich und nur in den Zwischenbereichen vollständig eingebettet ist.

Um die optische Auffälligkeit eines Sicherheitselements zu erhöhen und die Wertigkeit des zu schützenden Gegenstandes zu betonen, werden die Sicherheitselemente häufig mit silber- oder goldfarbenen Tönen ausgestattet.

Eine Möglichkeit, eine goldfarbene Beschichtung zu erreichen, besteht darin, dünne Goldschichten auf gut reflektierende Untergründe, wie z.B. Aluminium oder Silber, aufzudampfen. Allerdings ist aufgrund der hohen Kosten für das Ausgangsmaterial und des hohen technischen Aufwandes, der nötig ist, um sehr gleichmäßige Schichten zu erzeugen, keine Wirtschaftlichkeit gegeben.

Alternativ wurden auch Goldbronzen mittels Schiffchenverdampfung oder Sputtern aufgebracht. Bei der Schiffchenverdampfung wird ein Draht kontinierlich in ein heißes Schiffchen eingeführt. Ist das Schiffchen heiß genug, so verdampft das gerade zugeführte Drahtstück sofort und geht vollständig in.die Dampfphase über. Ein darüber liegendes Substrat wird mit genau der Zusammensetzung dieses Drahtstücks beschichtet. In den Schiffchen bilden sich jedoch häufig kleine Seen aus dem geschmolzenen Draht, der z.B. aus einer bestimmten Legierung besteht. Aus diesen Seen dampfen die einzelnen Komponenten der Legierung aufgrund unterschiedlichen Dampfdrucks mit unterschiedlicher Rate ab, wobei sich folglich die Mengenverhältnisse im abgeschiedenen Material und damit auf dem Substrat ändern. Der anfänglich eingestellte Farbton verändert sich somit laufend über die Beschichtungslänge und -breite des Bedampfungsgutes während des Bedampfens.

Weiterhin wird auch die Sputtertechnik eingesetzt. Hierbei werden aus einem festen Target im Plasma Metallcluster herausgeschlagen, die auf einen darüber liegend angeordneten Substrat kondensieren. Die Beschichtungszusammensetzung kann relativ konstant gehalten werden, jedoch ist Sputtern eine sehr zeitaufwändige Technik und weist somit eine sehr geringe Produktivität auf.

Der Erfindung liegt daher die Aufgabe zugrunde, ein Verfahren zur Herstellung von edelmetallfarbenen Beschichtungen, sowie mit diesem Verfahren beschichtete Gegenstände, insbesondere Sicherheitselemente und Wertdokumente mit derartigen Sicherheitselementen bereitzustellen. Das Verfahren soll insbesondere in wirtschaftlicher Weise einen konstanten Farbton der Beschichtung erzeugen. Die beschichteten Gegenstände sollen im Vergleich zum Stand der Technik erhöhte Fälschungssicherheit, z.B. durch ihr optisch auffälliges Erscheinungsbild aufweisen.

Diese Aufgabe wird durch die Merkmale der unabhängigen Ansprüche gelöst. Weiterbildungen sind Gegenstand der Unteransprüche.

Gemäß der Erfindung wird mittels Elektronenstrahl oder widerstandsbeheiztem Tiegel unter Erzeugung eines mehrkomponentigen Dampfes ein Verdampfungsgut verdampft, das eine edelmetallfarbene mehrkomponentige Beschichtung auf einem Substrat erzeugt. Bei der Elektronenstrahlbedampfung bzw. der Bedampfung mittels widerstandsbeheizten Tiegel handelt es sich um Vakuumbeschichtungsverfahren, mit denen sehr dünne, gleichmäßige Schichten aufgebracht werden können. Bei der Elektronenstrahlbedampfung wird mit einem Elektronenstrahl ein in einem Tiegel befindliches Verdampfungsgut erhitzt. Dabei wird Dampf erzeugt, der auf dem darüber geführten Substrat kondensiert. Anstelle des Elektronenstrahls kann dem Verdampfungsgut auch über Widerstandsbeheizung des Tiegels Energie zugeführt werden. Das Verdampfungsgut kann flüssig sein, wie z.B. eine Metallschmelze, und befindet sich in einem Tiegel. Es können auch Materialien verdampft werden, die sublimieren. Zum einen kann die Verdampfung aus einem Tiegel erfolgen, wobei es sich bei dem Verdampfungsgut in diesem Fall z.B. um ein mehrkomponentiges System, wie eine Legierung handeln kann. Zum anderen kann das Verdampfungsgut aus Einzelkomponenten bestehen, die sich in getrennten Tiegeln befinden. Jeder Tiegel wird von einem oder mehreren Elektronenstrahlen bzw. per Widerstandsheizung geheizt. Die Tiegel sind so angeordnet, dass sich die Dampfkeulen überhalb der Tiegel überlagern. Die Heizleistung der einzelnen Tiegel wird dabei so angepasst, dass sich eine mehrkomponentige Beschichtung, z.B. eine Legierung mit der gewünschten Zusammensetzung auf dem Substrat niederschlägt.

Da es sich bei den Komponenten des Verdampfungsgutes in der Regel um Substanzen mit unterschiedlichen Verdampfungsraten handelt, die z.B. von der Prozesstemperatur und den Dampfdrücken der einzelnen Komponenten abhängen, sind an das Verfahren hohe Anforderungen zu stellen. Um ein Substrat mit einer bestimmten Zusammensetzung zu beschichten, muss die Dampfphase die einzelnen Komponenten im gewünschten Mengenverhältnis aufweisen. Zu berücksichtigen ist jedoch, dass die Mengenverhältnisse, z.B. in der Schmelze einer Legierung, von den Mengenverhältnissen in der Dampfphase auf Grund der unterschiedlichen Dampfdrücke der Komponenten üblicherweise abweichen und daher entsprechend eingestellt werden müssen. Komponenten mit einem hohen Dampfdruck müssen daher üblicherweise in der Schmelze zu einem geringeren Anteil vorkommen, wohingegen Komponenten mit einem niedrigeren Dampfdruck üblicherweise höher konzentriert vorliegen müssen, um in der Dampfphase das gewünschte Mengenverhältnis zu erzielen. Die Zusanunensetzung der Schmelze ist so gezählt, dass bei einer bestimmten Temperatur im Dampf die gewünschte Zusammensetzung, die sich auf dem Substrat abscheiden soll, vorliegt. Die Zusammensetzung des Verdampfungsgutes wird sich zudem während des Aufdampfprozesses aufgrund der unterschiedlichen Abdampfraten der einzelnen Komponenten kontinuierlich verändern. Dieser Effekt kann entweder über Materialzufuhr bestimmter Verdampfungsgutkomponenten oder über das Verwenden von großen Schmelzvolumina kompensiert werden. Vorzugsweise werden die Schmelzvolumina so groß gewählt, dass ein Beschichtungszyklus ohne Nachführen von Verdampfungsgut durchgeführt werden kann.

Das Aufdampfen einer Legierung mit einer bestimmten Zusammensetzung und einer definierten Schichtdicke wird vorzugsweise über einen Regelungsmechanismus gesteuert, bei dem die aufgedampfte Schicht in Transmission und/-oder Reflexion gegebenenfalls an mehreren Stellen über die Bahnbreite des bedampften Substrates vermessen wird. Zur Messung von Transmission und/oder Reflexion werden dem Fachmann bekannte optische Geräte eingesetzt.

Bei der Transmissionsmessung wird die optische Dichte der abgeschiedenen Schicht und damit indirekt die Dicke der Schicht vermessen. Weicht die aufgedampfte Schichtdicke vom vorgegebenen Wert ab, kann diese über die Änderung der Bahngeschwindigkeit, mit der das zu bedampfende Substrat bewegt wird, und/oder über die Verdampfungsrate der aufzudampfenden Substanz beeinflusst werden. Die Verdampfungsrate kann dabei wiederum über die Energie des Elektronenstrahls oder die Heizleistung gesteuert werden. Ist die Schichtdicke beispielsweise höher als gewünscht, kann durch Erhöhen der Bahngeschwindigkeit die Menge an aufgedampfter Substanz pro Flächeneinheit verringert werden. Alternativ oder zusätzlich kann auch die Verdampfungsrate z.B. durch Absenken der Heizleistung oder durch Absenken der Energie des Elektronenstrahl reduziert werden.

Bei der Reflexionsmessung wird die Farbe der abgeschiedenen Schicht spektral vermessen und damit indirekt die Zusammensetzung eines mehrkomponentigen Verdampfungsgutes bestimmt. Üblicherweise wird dabei Weißlicht aufgestrahlt, das reflektierte Licht spektral analysiert und mittels Farbkoordinaten, z.B. nach dem Munsell-System oder dem CIE-System, beschrieben. Die Farbkoordinaten der aufgedampften Schicht werden mit einem vorher definierten Sollwert, der einer bestimmten Zusammensetzung des Verdampfungsgutes entspricht, verglichen, so dass aus der eventuellen Abweichung auf eine Abweichung in der Zusammensetzung geschlossen und gegebenenfalls gegengesteuert werden kann. Die Regelung erfolgt dabei über die Veränderung der Verdampfungsrate der Einzelkomponenten im mehrkomponentigen Verdampfungsgut, z.B. durch Erhöhen oder Erniedrigen der Elektronenstrahlenergie bzw. der Heizleistung.

Bei der Durchführung des Regelungsmechanismusses sind verschiedene Varianten denkbar. Im Folgenden werden bevorzugte Ausführungsformen beschrieben, bei denen zwei Tiegel jeweils eine Legierungskomponente enthalten, wobei die Erfindung nicht auf diese Varianten beschränkt sein soll.

### Variante A:

Die Heizleistung in Tiegel 1, in dem sich vorzugsweise die Hauptkomponente der Legierung befindet, wird fest eingestellt. Die Heizleistung ist so bemessen, dass diese erfahrungsgemäß zu einer gleichmäßig dicken Metallabscheidung über die gesamte Folienbreite, die üblicherweise ein bis zwei Meter beträgt, führt. Die in Tiegel 1 enthaltene Menge der Hauptkomponente in der Legierung ist dabei so groß, dass Änderungen der Gesamtheizleistung (Summe aus der Heizleistung in Tiegel 1 und Tiegel 2) sich nicht auf die Schichtdicke des abgeschiedenen Verdampfungsgutes auswirken. Eine Messung der Transmission zur Bestimmung der Schichtdicke ist daher nicht zwingend notwendig. Während der Beschichtung der Folie werden jedoch in Reflexion gegebenenfalls an mehreren Stellen über die Bahnbreite die Farbkoordinaten der aufgedampften Schicht gemessen und mit einem vorher definierten Sollwert verglichen. Die Abweichungen einer oder mehrerer Koordinaten werden nun zur Regelung der Heizleistung in Tiegel 2 verwendet. Handelt es sich bei Tiegel 2 um eine trogförmige Ausgestaltung, kann neben der Heizleistung im Tiegel 2 gegebenenfalls auch die Querverteilung der Heizleistung über der Troglänge geregelt werden.

### Variante B:

Wie in Variante A wird die Heizleistung in Tiegel 1, der vorzugsweise die Hauptkomponente der Legierung enthält, fest eingestellt, so dass erfahrungsgemäß eine gleichmäßig dicke Metallabscheidung über die Folienbreite erzielt wird. Während der Beschichtung der Folie wird in Transmission, gegebenenfalls an mehreren Stellen über die Bahnbreite, die optische Dichte der aufgedampften Schicht gemessen. Wurden an verschiedenen Stellen der Bahnbreite Werte ermittelt, wird der Mittelwert der optischen Dichte berechnet und mit einem vorgegebenen Sollwert für die Schichtdicke verglichen. Bei Abweichungen wird die Bahngeschwindigkeit, mit der die zu beschichtende Folie bewegt wird, entsprechend geregelt. Für die Regelung der Heizleistung in Tiegel 2 wird wie in Variante A verfahren.

### Variante C:

Hier wird bei konstanter Bahngeschwindigkeit, mit der das zu bedampfende Substrat vorwärts bewegt wird, die Verdampfungsrate sowohl in Tiegel 1 wie auch in Tiegel 2 geregelt. Die Verdampfungsraten werden hierbei wiederum über die Heizleistung bzw. die Energie des Elektronenstrahls gesteuert. Die Regelung der Verdampfungsraten wird dabei über die Transmissionsmessung der optischen Dichte der abgeschiedenen Schicht sowie mittels der Reflexionsmessung zur Bestimmung der Farbkoordinaten beeinflusst. Zur Erzeugung einer konstanten Schichtdicke und damit einer abgeschiedenen konstanten Gesamtmaterialmenge ist die Gesamtheizleistung im Tiegel 1 und 2 vorzugsweise konstant. Zur Erzeugung einer konstanten Legierungszusammensetzung wird vorzugsweise das Verhältnis der Heizleistungen in Tiegel 1 zu Tiegel 2 konstant eingeregelt.

Bei dem Verdampfungsgut handelt es sich vorzugsweise um ein mehrkomponentiges System, wie Verbindungen, Gemische oder Legierungen, das nach Abscheidung auf dem Substrat einen edelmetallfarbenen Ton erzeugt. Im Sinne der Erfindung ist dabei unter "edelmetallfarben" jeder Farbton zu verstehen, der silber- und/ oder goldfarbene-Anteile enthält. Je nach Zusammensetzung des Verdampfungsgutes enthält die Farbskala der Beschichtung also nicht nur die reinen Silber- oder Goldtöne. Die Farbskala der Silbertöne reicht vom mit Weißanteil angereichertem Silberton über Silbertöne mit hell- bis dunkelgrauen oder sogar schwarzen Anteilen. Die Farbskala der Goldtöne reicht von Hellgold, Nickel, Gold über Dunkelgold bis Bronze. Zusätzlich können durch entsprechende Maßnahmen auch z.B. gelb-, grün-, rot- und braunstichige edelmetallfarbene Töne erzeugt werden.

Vorzugsweise ist unter "edelmetallfarben" goldfarben zu verstehen, wobei goldfarben jeden denkbaren Goldton umfasst.

Vorzugsweise handelt es sich bei dem Verdampfungsgut um eine Legierung, insbesondere um Goldbronze. Unter "Goldbronze" im Sinne der Erfindung sind sämtliche Kupferlegierungen zu verstehen, insbesondere Legierungen, die Kupfer und Aluminium umfassen. Weitere bevorzugte Legierungen sind Legierungen umfassend Kupfer und Zinn, Legierungen umfassend Kupfer und Silber oder Legierungen umfassend Kupfer, Zinn und Silber. Vorzugsweise umfassen die auf dem Substrat abgeschiedenen Legierungen 95 bis 75 Gew. %, besonders bevorzugt 95 bis 85 Gew. %, insbesondere bevorzugt 92 Gew. % Kupfer. In einer besonders bevorzugten Ausführungsform umfasst die Legierung 5 bis 15 Gew. % Aluminium und 95 bis 85 Gew. % Kupfer. Die Zusammensetzung der auf das Substrat aufgedampften Schicht setzt sich vorzugsweise aus 8 Gew. % Aluminium und 92 Gew. % Kupfer zusammen, so dass sich ein goldfarbener Ton ergibt.

Zur Erzeugung weiterer Farbtöne, wie z.B. gelb-, grün-, rot- und braunstichiger Edelmetalltöne, insbesondere Goldtöne, besteht die Möglichkeit, der Legierung Fremdmetallanteile zuzumischen. Als Fremdmetalle eignen sich z.B. Eisen, Mangan, Vanadium, Chrom, Nickel, Cobalt, Silizium, Magnesium, Zink oder Titan. Vorzugsweise sind die Fremdmetallanteile zu mindestens in 5 Gew. % bezogen auf das auf dem Substrat abgeschiedene Verdampfungsgut enthalten. Selbstverständlich besteht auch die Möglichkeit, z.B. durch Erhöhen des Aluminiumsanteils, eher silbrig erscheinende Farbtöne zu erzeugen. Die jeweilige Zusammensetzung des Verdampfungsgutes zur Erzeugung der gewünschten Farbtöne auf dem Substrat können vom Fachmann durch entsprechende Vorversuche ermittelt werden.

Die Schichtdicken der aufgedampften Schicht auf dem Substrat betragen vorzugsweise mindestens 20 nm bis maximal 200 nm, insbesondere sind Schichtdicken von 50 bis 150 nm bevorzugt. Selbstverständlich sind Schichtdicken von unter 20 nm, beispielsweise wenige µm dicke Schichten, auch verwendbar.

Die erfindungsgemäß erzeugte mehrkomponentige Beschichtung lässt sich anhand verschiedener Kristallstrukturparameter, wie Korngröße, Brechungsindex und Leitfähigkeit von den Beschichtungen, die nach Verfahren gemäß Stand der Technik, wie z.B. Sputtern oder Schiffchenbedampfung erzeugt werden, unterscheiden. Die Analyse kann dabei je nach betrachtetem Parameter mehr oder weniger aufwändig sein, liegt aber im Bereich des Wissens eines Fachmanns.

Aufgrund der Möglichkeit, mehrere goldfarbene Töne zu erzeugen, bietet es sich auch an, ein Sicherheitselement mit mehreren Farbtönen auszustatten. Das erfindungsgemäße Sicherheitselement weist aber wenigstens eine edelmetallfarbene Beschichtung auf. Der optische Eindruck eines derartigen Sicherheitselements kann, wenn überhaupt, nur mit sehr hohem Aufwand limitiert werden, insbesondere wenn verschiedenfarbige Beschichtungen in komplizierten Mustern aufgebracht sind. Bei dem Sicherheitselement kann es sich um einen Sicherheitsfaden handeln, der aus einer selbsttragenden Kunststofffolie besteht, auf welche die edelmetallfarbigen Beschichtungen aufgebracht sind. Dieser Sicherheitsfaden kann zumindest teilweise in ein Sicherheitspapier bzw. Sicherheitsdokument eingebracht sein. Es ist allerdings auch denkbar, das Sicherheitselement band- oder etikettenförmig auszubilden und auf der Oberfläche des Sicherheitspapiers bzw. Wertdokuments zu befestigen.

Alternativ kann das Sicherheitselement auch als Transferelement ausgeführt sein. Diese Variante ist besonders vorteilhaft, wenn das Sicherheitselement vollständig auf der Oberfläche des Sicherheitspapiers bzw. Wertdokuments angeordnet ist. In diesem Fall wird der Schichtaufbau des Sicherheitselements auf einer Trägerfolie, üblicherweise einer Kunststofffolie, vorbereitet und anschließend in einem Heißprägeverfahren in den gewünschten Umrisskonturen auf das Sicherheitspapier bzw. Wertdokument übertragen.

Wird das Sicherheitselement auf der Oberfläche des Sicherheitspapiers bzw. Wertdokuments angeordnet, so kann es beliebige Umrissstrukturen, wie beispielsweise runde, ovale, sternförmige, rechteckige, trapezförmige oder streifenförmige Umrisskonturen aufweisen. Die Verwendung des erfindungsgemäßen Sicherheitselements ist jedoch nicht auf den Bereich des Sicherheitsdokuments beschränkt. Das erfindungsgemäße Sicherheitselement lässt sich auch auf dem Gebiet der Produktsicherung zur Fälschungssicherung beliebiger Waren vorteilhaft einsetzen. Hierfür kann das Sicherheitselement zusätzlich diebstahlsichernde Elemente, wie beispielsweise eine Spule oder einen Chip aufweisen. Analoges gilt für das mit einem derartigen Sicherheitselement versehene Sicherheitspapier bzw. Wertdokument.

Bei dem zu bedampfenden Substrat handelt es sich vorzugsweise um eine Kunststofffolie, bevorzugt aus PET (Polyethylenterephthalat), POP (Polyphenylenoxid), PEN (Polyethylennaphthalat) oder PC (Polycarbonat).

Die Kunststofffolie des Sicherheitselements kann zudem zusätzlich mit Beugungsstrukturen in Form einer Reliefstruktur versehen sein. Die Beugungsstrukturen können beliebige beugungsoptische Strukturen, wie Hologramme oder Gitterstrukturen (z.B. Kinegram^{®}, Pixelgramm) oder dergleichen sein. Üblicherweise werden diese Beugungsstrukturen in die Kunststofffolie eingeprägt.

Als weiteres optisch auffälliges Merkmal können in die erfindungsgemäße Beschichtung auch Aussparungen eingearbeitet werden, vorzugsweise mit Hilfe eines Waschverfahrens, wie es in der WO 99/13157 beschrieben ist, auf die hier ausdrücklich Bezug genommen wird. Die Sicherheitselemente werden dabei als Sicherheitsfolie, die mehrere Nutzen des Sicherheitselements aufweist, vorbereitet. Das Grundmaterial bildet eine selbsttragende, vorzugsweise transparente Kunststofffolie. Diese Kunststofffolie entspricht im Falle von Sicherheitsfäden oder Etiketten der erfindungsgemäßen Kunststoffschicht des Sicherheitselements. Werden die Sicherheitselemente aus einer Prägefolie herausgelöst, so bildet die Kunststofffolie das Trägermaterial dieses Transfermaterials, auf welches die Kunststoffschicht in Form einer Lackschicht aufgebracht ist. In diese Lackschicht oder, im Falle von Sicherheitsfäden oder Etiketten, in die Kunststofffolie können Beugungsstrukturen eingeprägt sein. Die erfindungsgemäße Kunststoffschicht des Sicherheitselements wird in Form der späteren Aussparungen vorzugsweise im Tiefdruck bedruckt. Hierfür wird eine Druckfarbe mit einem hohen Pigmentanteil verwendet, die einen porigen, erhabenen Farbauftrag bildet. Anschließend wird die Beschichtung auf die bedruckte Kunststoffschicht aufgedampft. In einem letzten Schritt schließlich wird der Farbauftrag und die darüber liegende erfindungsgemäße Beschichtung durch Auswaschen mit einer Flüssigkeit, eventuell kombiniert mit mechanischer Einwirkung, entfernt. Vorzugsweise wird eine wasserlösliche Druckfarbe verwendet, so dass als Flüssigkeit Wasser verwendet werden kann. Damit ist dieses Verfahren sehr umweltfreundlich und erfordert keine besonderen Schutzmaßnahmen.

Das Auswaschen kann durch mechanische Mittel, wie eine rotierende Walze, Bürste oder Ultraschall; unterstützt werden.

Die Verwendung von Ätztechniken ist zwar wesentlich aufwändiger, aber im Prinzip ebenfalls möglich. Hier wird zuerst die erfindungsgemäße Beschichtung auf der Kunststoffschicht abgeschieden und anschließend die gesamte Oberfläche bis auf die zu entfernenden Bereiche mit einer schützenden Lackschicht bedruckt. Der gesamte Sicherheitselement-Schichtaufbau wird anschließend durch ein Ätzbad geführt, in dem die nicht abgedeckten Bereiche von der Kunststoffschicht abgelöst werden. Sofern für unterschiedliche Beschichtungen unterschiedliche Ätzbäder notwendig sind, muss der Vorgang des Abdeckens bzw. des Eintauchens in ein Ätzbad mit verschiedenen Ätzlösungen wiederholt werden. Zwischen den einzelnen Ätzbädern sind Neutralisations- und fteinigungsbäder vorzusehen, damit die Chemikalien der einzelnen Bäder nicht verunreinigt werden.

Andere Verfahren sind ebenfalls denkbar, wie z.B. mechanisches Entfernen der erfindungsgemäßen Beschichtung oder das Erzeugen der Unterbrechungen mittels Laserstrahlschreiber, Elektronenstrahlerosion oder andere Abtragungsverfahren.

Die erfindungsgemäß bedampften Substrate können weiterbearbeitet werden, indem die aufgedampfte Schicht z.B. mechanisch vom Substrat abgeschabt wird, so dass feine Plättchen erzeugt werden. Diese Plättchen können vorzugsweise in Druckfarben eingearbeitet werden und als solche für Sicherheitselemente verwendet werden.

Das erfindungsgemäße Beschichtungsverfahren bietet den Vorteil, dass mit ihm in äußerst wirtschaftlicher Weise, d.h. kosten- und zeitsparend, edelmetallfarbene Beschichtungen erzeugt werden können, die im Vergleich zum Stand der Technik hinsichtlich Farbton und Schichtdicke äußerst gleichmäßig ausgeführt sind.

Aufgrund der optisch auffälligen Beschichtung weisen die erfindungsgemäß hergestellten Sicherheitselemente und Wertdokumente eine entsprechend erhöhte Fälschungssicherheit auf, da sie ohne weiteres Hilfsmittel leicht erkennbar sind.

Weitere Ausführungsformen und Vorteile des erfindungsgemäßen Verfahrens, des Sicherheitselements bzw. Sicherheitspapiers und Wertdokuments werden anhand des Beispiels und der Figuren erläutert.

### Beispiel 1:

In einer Elektronenstrahlbedampfungsanlage werden Folien aus PET, alternativ aus POP, PC oder PEN, mit einer Breite von 1000 mm mit einer etwa 55 nm dicken Schicht aus 8 Gew. % Aluminium und 92 Gew. % Kupfer beschichtet. Die Verdampfung erfolgt aus einem Tiegel, dessen Fassungsvermögen mindestens so groß ist, dass ein Beschichtungszyklus ohne Nachführen von Material durchgeführt werden kann. Das Verdampfungsgut, eine Aluminium/Kupfer-Legierung, wird mit einer Elektronenkanone erhitzt. Da Kupfer in der Schmelze den höheren Dampfdruck aufweist als Aluminium, herrscht im Dampf ein höherer Kupferanteil vor als im Vergleich zur Schmelze. Auf einem durch den Dampf bewegten Substrat würde sich daher ein kupferfarbener Film abscheiden. Um dieses Problem zu umgehen, wird der Anteil von Aluminium relativ zum Kupfer in der Schmelze erhöht. Daher werden 80 % Kupfer und 20 % Aluminium in der Schmelze verwendet, die einen silbrigen Farbton aufweist. Der Dampf oberhalb der Schmelze weist jedoch ein Kupfer-Aluminium-Verhältnis auf, der zu goldfarbenen Niederschlägen mit dem oben angegebenen Aluminium/Kupferverhältnis (8/92) auf einem Substrat führt. Über längere Aufdampfzeiten ändert sich aufgrund der höheren Abdampfrate von Kupfer das Mischungsverhältnis zugunsten des Aluminiums. Dieser Effekt wird entweder aufgefangen durch Nachfüttern von Kupfer oder durch Verwendung von großen Volumina der Schmelze. Bei Verwendung von großen Schmelzmengen verändert sich das Mischungsverhältnis während eines Beschichtungszyklus nur geringfügig und der Farbton der aufgedampften Schicht bleibt gleichmäßig.

### Beispiel 2:

Diese Ausführungsform entspricht der im Beispiel 1 beschriebenen und unterscheidet sich von Beispiel 1 darin; dass das Verdampfungsgut nicht mittels Elektronenstrahl, sondern mittels eines widerstandsbeheizten Tiegels zum Schmelzen gebracht und verdampft wird.

Die folgenden Figuren sind schematisiert und entsprechen nicht unbedingt den tatsächlichen Größenverhältnissen und Proportionen. Es zeigen:
- Fig. 1: ein erfindungsgemäßes Wertdokument,
- Fig. 2: einen Querschnitt durch das erfindungsgemäße Wertdokument entlang der Linie A - A und
- Fig. 3a, 3b: einen schematischen Aufbau einer Bedampfungsvorrichtung.

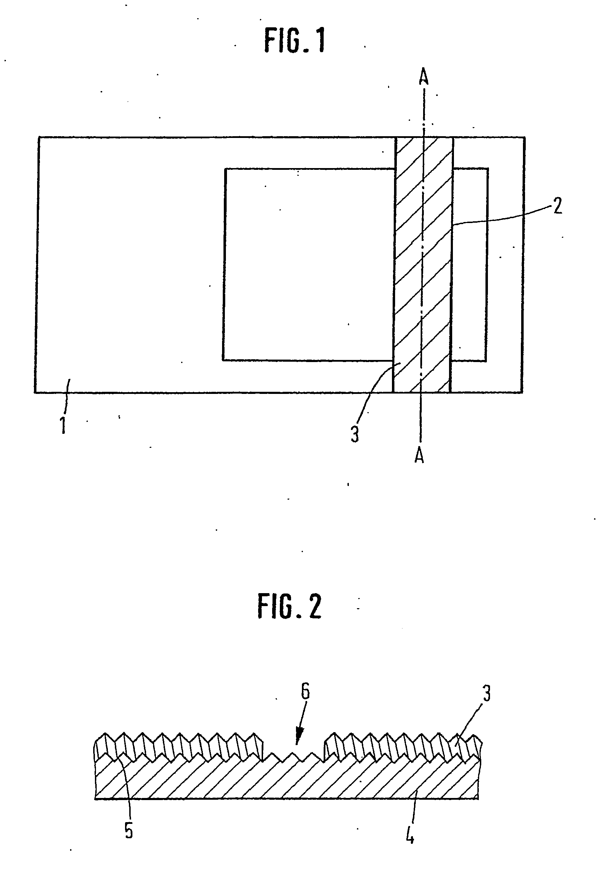

Fig. 1 zeigt ein erfindungsgemäßes Wertdokument in Aufsicht. Im gezeigten Beispiel handelt es sich um eine Banknote 1. Diese Banknote weist ein streifenförmiges Sicherheitselement 2 auf, das sich über die gesamte Breite der Banknote 1 erstreckt. Die gesamte dem Betrachter zugewandte Oberfläche des Sicherheitselements 2 erscheint goldfarben.

Bei dem in Fig.1 dargestellten Sicherheitselement handelt es sich um ein beugungsoptisches Sicherheitselement, das aus einer geprägten Kunststoffschicht und wenigstens einer goldfarbenen nach dem Beispiel 1 erzeugten Schicht 3 besteht.

Fig. 2 zeigt einen Querschnitt entlang der Linie A - A in Fig.1. Hier ist die Kunststoffschicht 4 zu erkennen, in welche die Beugungsstruktur 5 eingebracht ist. Darüber ist direkt angrenzend die erfindungsgemäße goldfarbene Beschichtung 3 angeordnet, in die eine Aussparung 6 eingearbeitet ist. Bei den Aussparungen kann es sich um beliebige Zeichen, alphanumerische Zeichen, Muster, Logos oder dergleichen handeln.

Bei dem in Fig. 2 dargestellten Sicherheitselement kann es sich beispielsweise um einen Sicherheitsfaden handeln. Der Sicherheitsfaden besteht aus einer vorzugsweise transparenten Trägerfolie 4, auf welcher die goldfarbene Beschichtung 3 angeordnet ist.

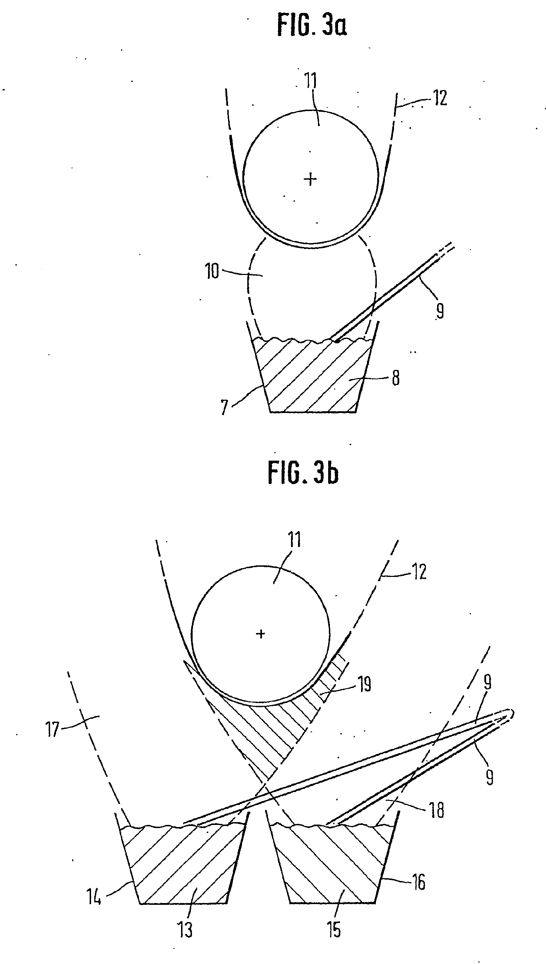

Fig. 3a zeigt schematisch eine Versuchsanordnung, bei der sich in einem Tiegel 7 eine Cu/Al-Legierung 8 befindet. Mittels Elektronenstrahl 9 wird die Legierung zur Schmelze gebracht und bei weiterer Energiezufuhr verdampft. Über dem Schmelztiegel bildet sich eine Dampfkeule 10 mit einer bestimmten Cu/Al-Zusarrunensetzung aus. In diese Dampfkeule 10 wird eine auf einer Kühlwalze 11 geführte Folie 12 eingebracht, auf der sich eine Cu/Al-Legierung mit gewünschter Zusammensetzung abscheidet.

Fig. 3b zeigt eine zu der in Fig. 3a beschriebene alternative Prozessführung. Das Verdampfungsgut setzt sich hier aus zwei Einzelkomponenten in getrennten Tiegeln, nämlich Cu 13 in Tiegel 14 und Al 15 in Tiegel 16, zusammen. Die Einzelkomponenten werden mittels Elektronenstrahl 9 geschmolzen und verdampft, so dass sich über den Tiegeln zwei Dampfkeulen 17,18 ausbilden, die sich im Bereich 19 überlagern. Aufgrund der Überlagerung weist die Dampfphase wiederum eine bestimmte Cu/Al-Zusammensetzung auf. Wie unter Fig. 3a beschrieben, wird eine auf einer Kühlwalze 11 geführte Folie 12 in die Dampfphase eingebracht, so dass sich eine Legierung aus Cu und Al mit gewünschter Zusammensetzung abscheiden kann.

### Bevorzugte Ausführungsformen der Erfindung:

I. Verfahren zum Bedampfen eines Substrates mit einem mehrkomponentigen Verdampfungsgut, das mittels Elektronenstrahl oder Widerstandsheizung in die Dampfphase überführt wird, **dadurch gekennzeichnet, dass** sich das verdampfte Verdampfungsgut als edelmetallfarbene Beschichtung auf dem Substrat absetzt.
II. Verfahren nach Absatz I, wobei die edelmetallfarbene Beschichtung goldfarben ist.
III. Verfahren nach Absatz I oder II, wobei es sich bei dem Verdampfungsgut um Einzelkomponenten in getrennten Tiegeln handelt
IV. Verfahren nach wenigstens einem der Absätze I bis III, wobei es sich bei dem Verdampfungsgut um eine Legierung handelt.
V. Verfahren nach wenigstens einem der Absätze I bis IV, wobei das Verdampfungsgut ein oder mehrere Metalle aus der Gruppe enthaltend Kupfer (Cu), Aluminium (Al), Zinn (Sn) und Silber (Ag) umfasst.
VI. Verfahren nach wenigstens einem der Absätze I bis V, wobei das Verdampfungsgut Al/Cu oder Sn/Cu oder Ag/Cu oder Ag/Sn/Cu umfasst.
VII. Verfahren nach wenigstens einem der Absätze I bis VI, wobei die Beschichtung Aluminium zu 5 bis 15 Gew. % und Kupfer zu 85 bis 95 Gew. % umfasst.
VIII. Verfahren nach wenigstens einem der Absätze I bis VII, wobei das Verdampfungsgut mindestens ein Fremdmetall umfasst.
IX. Verfahren nach Absatz VIII, wobei das Fremdmetall ausgewählt ist aus der Gruppe Eisen, Mangan, Vanadium, Chrom, Cobalt, Silizium, Magnesium, Zink und Titan.
X. Verfahren nach wenigstens einem der Absätze I bis IX, wobei auf dem Substrat verschiedene edelmetallfarbene Beschichtungen abgeschieden werden.
XI. Verfahren nach wenigstens einem der Absätze I bis X, wobei es sich bei dem Substrat um eine Kunststofffolie handelt.
XII. Verfahren nach wenigstens einem der Absätze I bis XI, wobei die Beschichtung in einer Schichtdicke von 50 bis 100 nm abgeschieden wird.
XIII. Verfahren nach wenigstens einem der Absätze I bis XII, wobei in das Substrat vor der Beschichtung Beugungsstrukturen eingeprägt werden.
XIV. Verfahren nach wenigstens einem der Absätze I bis XIII, wobei das Substrat nach der Beschichtung streifen- bzw. bandförmig geschnitten wird.
XV. Verfahren nach wenigstens einem der Absätze I bis XIV, wobei die Schichtdicke der Beschichtung mittels Transmissionsmessung und/oder die Zusammensetzung der Beschichtung mittels Reflexionsmessung bestimmt wird, und gegebenenfalls möglicherweise vorliegende Abweichungen der Schichtdicke und/oder der Zusammensetzung vom Sollwert mittels Heizleistung und/oder Bahngeschwindigkeit, mit der das zu beschichtende Substrat bewegt wird, korrigiert werden.
XVI. Verfahren nach wenigstens einem der Absätze I bis XV, wobei die Beschichtung vom Substrat entfernt wird und zu Plättchen zerbrochen wird, und diese gegebenenfalls zu Druckfarbe verarbeitet werden.
XVII. Gegenstand, insbesondere Sicherheitselement oder Transferelement für Sicherheitspapiere, Banknoten, Ausweiskarten und dergleichen, hergestellt nach wenigstens einem der Absätze I bis .XVI.
XVIII. Gegenstand, insbesondere Sicherheitselement oder Transferelement für Sicherheitspapiere, Banknoten, Ausweiskarten und dergleichen mit einem Substrat, auf dem mindestens eine Beschichtung aus einer edelmetallfarbenen Legierung vorliegt.
XIX. Gegenstand, insbesondere Sicherheitselement oder Transferelement nach Absatz XVIII ,wobei die Legierung goldfarben ist.
XX. Gegenstand, insbesondere Sicherheitselement oder Transferelement nach Absatz XVIII oder XIX, wobei die Legierung Kupfer umfasst.
XXI. Gegenstand, insbesondere Sicherheitselement oder Transferelement nach wenigsten einem der Ansätze XVIII bis XX, wobei die Legierung Aluminium und/oder Zinn und/oder Silber umfasst.
XXII. Gegenstand, insbesondere Sicherheitselement oder Transferelement nach wenigsten einem der Absätze XVIII bis XXI, wobei die Legierung Aluminium zu 8 Gew. % und Kupfer zu 92 Gew. % umfasst.
XXIII. Gegenstand, insbesondere Sicherheitselement oder Transferelement nach wenigsten einem der Absätze XVIII bis XXII, wobei die Legierung mindestens ein Fremdmetall umfasst.
XXIV. Gegenstand, insbesondere Sicherheitselement oder Transferelement nach Absatz XXIII, wobei das Fremdmetall ausgewählt ist aus der Gruppe Eisen, Mangan, Vanadium, Chrom, Cobalt, Silizium, Magnesium, Zink und Titan.
XXV. Gegenstand, insbesondere Sicherheitselement oder Transferelement nach wenigsten einem der Absätze XVIII bis XXIV, wobei es sich bei dem Substrat um eine Kunststofffolie handelt.
XXVI. Gegenstand, insbesondere Sicherheitselement oder Transferelement nach wenigsten einem der Absätze XVIII bis XXV, wobei die Beschichtung eine Schichtdicke von 50 bis 100 nm aufweist.
XXVII. Gegenstand, insbesondere Sicherheitselement oder Transferelement nach wenigstens einem der Absätze XVIII bis XXVI, wobei die Beschichtung wenigstens teilweise mit Beugungsstrukturen überlagert ist.
XXVIII. Gegenstand, insbesondere Sicherheitselement oder Transferelement nach Absatz XXVII, wobei die Beugungsstrukturen in das Substrat eingeprägt sind.
XXIX. Gegenstände, insbesondere Sicherheitselement nach wenigstens einem der Absätze XVII bis XXVIII, wobei das Sicherheitselement ein selbsttragendes Etikett ist.
XXX. Gegenstand, insbesondere Sicherheitselement nach wenigstens einem der Ansätze XVII bis XXVIII, wobei das Sicherheitselement ein Sicherheitsfaden ist.
XXXI. Sicherheitspapier für die Herstellung von Wertdokumenten oder Wertdokument, **dadurch gekennzeichnet, dass** es wenigstens ein Sicherheitselement gemäß einem der Absätze XVII bis XXX aufweist.
Sicherheitspapier oder Wertdokument gemäß Absatz XXXI, wobei das Sicherheitselement ein Sicherheitsfaden ist und zumindest teilweise in das Sicherheitspapier eingebettet ist.
XXXIII. Sicherheitspapier oder Wertdokument gemäß Absatz XXXI , wobei das Sicherheitselement ein Transferelement ist, das auf die Oberfläche des Sicherheitspapiers aufgebracht ist.
XXXIV. Verwendung eines Sicherheitselements oder Transferelements gemäß wenigstens einem der Ansätze XVII bis XXX für die Fälschungssicherung von Waren beliebiger Art.
XXXV. Verwendung eines Sicherheitspapiers oder Wertdokuments gemäß wenigstens einem der Absätze XXXI bis XXXIII für die Fälschungssicherung von Waren beliebiger Art.
XXXVI. Druckfarbe, hergestellt nach Absatz XVI.

## Patentansprüche

1. Sicherheitselement oder Transferelement zur Sicherung von Wertdokumenten oder zur Produktsicherung, mit einem Substrat, auf dem mindestens eine Beschichtung vorliegt, wobei die Beschichtung erhältlich ist durch Bedampfen des Substrats mit einem mehrkomponentigen Verdampfungsgut, das mittels Elektronenstrahl oder Widerstandsheizung in die Dampfphase überführt wird, wobei sich das verdampfte Verdampfungsgut als edelmetallfarbene Beschichtung auf dem Substrat absetzt,
**dadurch gekennzeichnet,**
**dass** die Zusammensetzung der Beschichtung mittels Reflexionsmessung bestimmt wird, und dass gegebenenfalls möglicherweise vorliegende Abweichungen der Zusammensetzung vom Sollwert mittels Änderung der Heizleistung und/oder der Elektronenstrahlenergie korrigiert werden.

2. Sicherheitselement oder Transferelement nach Anspruch 1, wobei die Beschichtung eine edelmetallfarbene Legierung ist.

3. Sicherheitselement oder Transferelement nach Anspruch 1 oder 2, wobei die Beschichtung goldfarben ist.

4. Sicherheitselement oder Transferelement nach einem der Ansprüche 1 bis 3, wobei die Beschichtung Kupfer umfasst.

5. Sicherheitselement oder Transferelement nach einem der Ansprüche 1 bis 4, wobei die Beschichtung Aluminium und/oder Zinn und/oder Silber umfasst.

6. Sicherheitselement oder Transferelement nach einem der Ansprüche 1 bis 5, wobei die Beschichtung Aluminium zu 5 bis 15 Gew.-% und Kupfer zu 85 bis 95 Gew.-% umfasst.

7. Sicherheitselement oder Transferelement nach Anspruch 6, wobei die Beschichtung Aluminium zu 8 Gew.-% und Kupfer zu 92 Gew.% umfasst.

8. Sicherheitselement oder Transferelement nach einem der Ansprüche 1 bis 7, wobei die Beschichtung mindestens ein Fremdmetall umfasst.

9. Sicherheitselement oder Transferelement nach Anspruch 8, wobei das Fremdmetall ausgewählt ist aus der Gruppe, die aus Eisen, Mangan, Vanadium, Chrom, Cobalt, Silizium, Magnesium, Zink und Titan besteht.

10. Sicherheitselement oder Transferelement nach einem der Ansprüche 1 bis 9, wobei auf dem Substrat verschiedene edelmetallfarbene Beschichtungen vorliegen.

11. Sicherheitselement oder Transferelement nach einem der Ansprüche 1 bis 10, wobei es sich bei dem Substrat um eine Kunststofffolie handelt.

12. Sicherheitselement oder Transferelement nach einem der Ansprüche 1 bis 11, wobei die Beschichtung eine Schichtdicke von 50 bis 100 nm aufweist.

13. Sicherheitselement oder Transferelement nach einem der Ansprüche 1 bis 12, wobei die Beschichtung wenigstens teilweise mit Beugungsstrukturen überlagert ist.

14. Sicherheitselement oder Transferelement nach Anspruch 13, wobei die Beugungsstrukturen in das Substrat eingeprägt sind.

15. Sicherheitselement oder Transferelement nach einem der Ansprüche 1 bis 14, wobei außerdem die Schichtdicke der Beschichtung mittels Transmissionsmessung bestimmt wird, und gegebenenfalls möglicherweise vorliegende Abweichungen der Schichtdicke vom Sollwert mittels Änderung der Heizleistung und/oder der Elektronenstrahlenergie und/oder der Bahngeschwindigkeit, mit der das zu beschichtende Substrat bewegt wird, korrigiert werden.

16. Sicherheitselement nach einem der Ansprüche 1 bis 15, wobei das Sicherheitselement ein selbsttragendes Etikett ist.

17. Sicherheitselement nach einem der Ansprüche 1 bis 15, wobei das Sicherheitselement ein Sicherheitsfaden ist.

18. Sicherheitspapier für die Herstellung von Wertdokumenten, oder Wertdokument,
**dadurch gekennzeichnet,**
**dass** es mindestens ein Sicherheitselement gemäß einem der Ansprüche 1 bis 17 aufweist.

19. Sicherheitspapier oder Wertdokument nach Anspruch 18, wobei das Sicherheitselement ein Sicherheitsfaden ist und zumindest teilweise in das Sicherheitspapier eingebettet ist.

20. Sicherheitspapier oder Wertdokument nach Anspruch 18, wobei das Sicherheitselement ein Transferelement ist, das auf die Oberfläche des Sicherheitspapiers aufgebracht ist.

21. Verwendung eines Sicherheitselements oder Transferelements nach einem der Ansprüche 1 bis 17 zur Fälschungssicherung von Waren beliebiger Art.

22. Verwendung eines Sicherheitspapiers oder Wertdokuments nach einem der Ansprüche 18 bis 20 zur Fälschungssicherung von Waren beliebiger Art.

23. Druckfarbe, erhältlich **dadurch**, dass eine gemäß einem der Ansprüche 1 bis 17 auf einem Substrat ausgebildete Beschichtung von dem Substrat entfernt und zu Plättchen zerbrochen wird, wobei die Plättchen zu der Druckfarbe verarbeitet werden.
